# EUROPEAN PATENT APPLICATION

(11) **EP 3 403 826 A1**
(43) Date of publication of application: **21.11.2018**
(21) Application number: 17305568.2
(22) Date of filing: 17.05.2017
(51) Int. Cl.: B32B 37/10, H01L 31/048, B30B 15/34, B32B 37/06

(54) **LAMINATION PROCESS IN PARTICULAR FOR MANUFACTURING PHOTOVOLTAIC LAMINATES AND LAMINATION DEVICE IMPLEMENTING SAID LAMINATION PROCESS**

(71) Applicant: Total SA, 92400 Courbevoie (FR)
(72) Inventor: CASSAGNE, Valérick, 91470 LIMOURS (FR)
(74) Representative: Croonenbroek, Thomas Jakob

(57) **Abstract**

The present invention relates to a lamination process, for manufacturing photovoltaic laminates by encapsulation, using a lamination device (3) comprising a lamination chamber (5) having a base plate (7) and a movable top plate (9), and comprising the steps of:
**•** heating the base plate (7),
**•** depositing a stack of layers (10) into the lamination chamber (5),
**•** pumping down and degassing the lamination chamber (5),
**•** pressing onto the stack of layers (10) with the movable top plate (9) during a predetermined time in order to realize a lamination step,
**•** removing the laminated photovoltaic laminate formed from the lamination chamber (5),
wherein the stack of layers (10) is placed on a support structure (23) configured for providing a predetermined thermal inertia, a predetermined bulk thermal resistance and a predetermined surface thermal resistance between the base plate (7) and the stack of layers (10) to delay polymerization or glass transition between the layers of the stack.

## Description

The present invention relates to the manufacturing of photovoltaic modules and more precisely to the manufacturing of photovoltaic laminates by encapsulation, also known as lamination process. Thus, the present invention relates to a lamination process for the manufacturing of photovoltaic laminates and to a lamination device configured for implementing the lamination process according to the present invention.

Nowadays, photovoltaic laminates are generally manufactured by a lamination process to obtain photovoltaic laminates having a small thickness. This lamination process consists in pressing under heat and vacuum a stack of layers composing the photovoltaic laminate. The stack of layers is generally composed by a first encapsulation foil, strings with photovoltaic cells, and a second encapsulation foil. Optionally, the stack of layers can comprise a protection layer disposed on the first encapsulation foil and a back layer disposed under the second encapsulation foil. The optional protective layer can be made of polymer or glass. Generally, the encapsulation foils are made of a polymer able to reticulate during a polymerization reaction to allow a strong adherence between the different pressed layers composing the photovoltaic laminate. Moreover, those encapsulation foils enhance the resistance of the different layers composing the photovoltaic laminate against humidity for example.

Polymerization reactions used in lamination processes are reticulation reactions. Those reactions are irreversible and temperature dependent. Thus, the lamination process implements a lamination device comprising a housing which corresponds to a traditional oven having a door, or the lamination device can be a bell type furnace. The commercially available lamination devices have generally an almost fixed temperature in order to have a high inertia for temperature stability purposes. However, to improve the performance and the quality of the photovoltaic laminates, it is necessary to avoid the presence of bubbles, which could be due to the air present in the lamination chamber or to the vapors produced during the degassing of the polymer composing the encapsulation foils, into the photovoltaic laminates and in particular between the different layers of the stack. This is generally performed by the use of a vacuum pump which removes the air from a lamination chamber into which the stack of layers aimed at forming the photovoltaic laminate is deposited and the vapors produced during the degassing of the polymer composing the encapsulation foils. Nevertheless, this vacuum step has to be completed before the starting of the polymerization reaction. If not, bubbles can be formed and trapped into the encapsulation foils between the different layers of the photovoltaic laminate and decrease its performance.

El Amrani & al. ("Solar Module Fabrication", International Journal of Photoenergy, vol. 2007) have developed a process for manufacturing photovoltaic laminates implementing a degassing step. According to this process, the stack of layers is introduced into a lamination device which is heated at a first temperature, approximately 50-60°C, which is less than the polymerization temperature of the encapsulation foils. During this first step, the air into the lamination device is removed by the use of a vacuum pump and the pressure into the lamination chamber is maintained at 0,1 mmHg (approximately 13 Pa) during the lamination process. The stack of layers is then pressed and the lamination device heated at a second temperature which is approximately equal to the polymerization temperature of the encapsulation foils to allow their polymerization reaction. After a predetermined time, the pressure onto the stack of layer and the heating are stopped, the lamination chamber is vented, and the laminated stack of layer forming a laminated photovoltaic laminated is removed from the lamination chamber.

However, this process is difficult to implement with traditional lamination devices, whose heating temperatures are fixed. Moreover, this process is time and cost expensive, because the lamination device has to heat the stack of layers at a first and then at a second temperature, this results in an increase of the processing time. In addition, energy consumption is quite important because of alternating heating and cooling.

Thus, it is useful to develop a lamination process which can be implemented with traditional lamination devices, and more precisely a lamination process which could be implemented in a lamination chamber set at a predetermined fixed temperature.

Another objective of the present invention, different from the precedent objective, is to propose a process which allows a decrease of the costs to manufacture photovoltaic laminates due to an implementation at a constant temperature with a single lamination chamber.

A further objective, different from the preceding objectives, is to provide a lamination process which allows the decrease of the processing time to manufacture photovoltaic laminates with a single lamination chamber.

Another objective of the present invention is to provide a lamination device which allows the control of the starting of the polymerization reaction and which enables to operate at a constant temperature.

In order to solve at least partially at least one of the here-above mentioned prior art drawbacks, the present invention relates to a lamination process, in particular for manufacturing photovoltaic laminates by encapsulation, using a lamination device comprising a lamination chamber having a base plate and a movable top plate, said lamination process comprising the steps of:
- heating the base plate at a predetermined temperature,
- depositing a stack of layers aimed at forming the photovoltaic laminate into the lamination chamber between the base plate and the movable top plate,
- pumping down and degassing the lamination chamber by the use of a vacuum pump,
- pressing onto the stack of layers with the movable top plate during a predetermined time in order to realize a lamination step,
- venting the lamination chamber, and
- removing the laminated photovoltaic laminate formed from the lamination chamber,
wherein the stack of layers is placed on a support structure configured for providing a predetermined thermal inertia, a predetermined bulk thermal resistance and a predetermined surface thermal resistance between the base plate and the stack of layers to slow down the temperature rise of the stack of layers and delay polymerization or glass transition between the layers of the stack.
The thermal inertia is defined as the energy needed to heat one square meter of support structure by one Kelvin, its unit is J.m⁻².K⁻¹. It can be determined by heat capacity (J.kg⁻¹.K⁻¹) x density (kg.m⁻³) x thickness (m).
The bulk thermal resistance is the opposite of thermal conductivity per square meter of support structure, it unit is K.m².W⁻¹. It can be determined by the opposite of thermal conductivity (m.K.W⁻¹) x thickness (m).
The surface thermal resistance is the opposite of thermal conductance per square meter of the lower surface of the support structure, it unit is K.m².W⁻¹.

The use of a support structure delays the polymerization reaction or glass transition of encapsulation foils of the stack of layer and allows the vacuum pump to remove air and vapors from the lamination chamber and in particular between the layers of the stack to avoid the formation of bubbles and voids and improve the performance of the photovoltaic laminate obtained by this lamination process.

Moreover, the use of this support structure allows the use of a commercially available lamination device which is configured for heating the stack of layers at a predetermined constant temperature. Thus, the lamination process can be implemented at a constant temperature. Furthermore, the use of a process implementing a constant temperature ensures a decrease of the energetic consumptions and thus enables a decrease of the costs of the process.

Then, the use of the support structure enables an optimization of the processing time. Effectively, the lamination device can be maintained at a constant temperature. Thus, the temperature rise between the first temperature, in which the lamination chamber is degassed, and the second temperature, in which the polymerization reaction or a glass transition occurs, is mastered through the support structure which allows to accelerate the process and to improve the process efficiency.

The lamination process according to the present invention can have one or more of the following characteristics taken separately or in combination.

The support structure comprises a plate with a predetermined thermal inertia, a predetermined surface thermal resistance and a predetermined bulk thermal resistance, said predetermined thermal inertia being less than 10⁵ J.m⁻².K⁻¹, and more preferably comprised between 5x10² and 5x10⁴ J.m⁻².K⁻¹, and said predetermined surface thermal resistance being comprised between 2x10⁻⁶ m².K.W⁻¹ and 5x10⁻² m².K.W⁻¹, and said predetermined bulk thermal resistance being comprised between 1x10⁻⁶ m².K.W⁻¹ and 2x10⁻¹ m².K.W⁻¹

The plate is made of metal, glass, glass comprising thermal conductive particles, polymer, phase change material, ceramic, or a combination thereof.

The plate has a thickness comprised between 0,1 mm and 20 mm, and more preferably comprised between 2 mm and 10 mm.

The base plate is heated at a constant temperature which is between 80°C and 200°C, in particular comprised between 100 and 160°C.

According to a particular embodiment, the pumping down and degassing steps are performed for a period of less than 10 minutes, and in particular comprised between 30s and 2 minutes.

The plate has a predetermined thermal inertia, a predetermined surface thermal resistance with respect to the base plate and a predetermined bulk thermal resistance such that the steps of pumping down and degassing are completed before the stack of layers reaches a predetermined polymerization or glass transition threshold temperature.

According to a particular embodiment, the step of pressing is performed after a predetermined time after the deposition step of the support structure with the stack of layers into the lamination chamber.

According to another embodiment, the pressing step is performed once the pressure into the lamination chamber is lower than a predetermined threshold.

According to this other particular embodiment, the predetermined threshold is 20 mbar, and more preferably 1 mbar.

According to this embodiment, the plate has a predetermined thermal inertia, a predetermined surface thermal resistance with respect to the base plate and a predetermined bulk thermal resistance such that the predetermined threshold temperature for polymerization or glass transition is not yet reached when the pressure into the lamination chamber is equal to a pressure threshold, in particular a pressure threshold of 1 mbar.

According to a particular embodiment, the support structure comprises mechanical springs configured for collapsing by the pressure of the movable top plate onto the stack of layers to bring the support structure into contact with the base plate during the pressing step therefore decreasing the surface thermal resistance between the support structure and the base plate.

The present invention further relates to a lamination device, in particular for manufacturing photovoltaic laminates by encapsulation, said lamination device comprising a base plate configured to be heated at a predetermined constant temperature and a movable top plate configured for pressing onto a stack of layers aimed at forming the photovoltaic laminate, said lamination device further comprising a support structure as defined here-above.

Other features and advantages would appear by reading the following description, given as an illustrative and non-restrictive example, and with the annexed drawings in which:
- figure 1 is a schematic cross sectional view of an empty lamination device according to a first embodiment,
- figure 2 is a schematic cross sectional view of the lamination device of figure 1 loaded with a support structure onto which is disposed a stack of layers,
- figure 3 is a schematic cross sectional view of the lamination device of figure 1 during a pressing step onto the stack of layers,
- figure 4 is a schematic cross sectional view of the lamination device of figure 1 with a photovoltaic laminate obtained after the pressing step,
- figure 5 is a schematic cross sectional view of a stack of layer disposed onto a support structure according to a second embodiment,
- figure 6 is a schematic cross sectional view of a lamination device loaded with the support structure of figure 5,
- figure 7 is a schematic cross sectional view of the lamination device during a pressing step onto the stack of layer with the support structure of figure 5,
- figure 8 is a schematic cross sectional view of the lamination device with a photovoltaic laminate obtained after the pressing step onto the support structure of figure 5, and
- figure 9 is a flowchart illustrating the lamination process according to the processing time.

On the drawings, the same elements have the same numeral references.

The following embodiments are examples. Even if the specification refers to one or more embodiments, this does not necessary imply that each reference concerns the same embodiment, or that the technical features may only be applied to one and only embodiment. Simple technical features of different embodiments may be combined or interchanged in order to obtain other embodiments.

In the following specification, the term "lamination device" is intended to refer to a bottom side heat source lamination device. More precisely, the stack of layers to be laminated disposed into the lamination chamber is heated from the bottom of the stack to the top.

Moreover, in the following specification, the terms "lower", "bottom" and "top" are defined according to the standard vertical axis, and are corresponding to the general configuration of the disposed elements into the lamination device.

Furthermore, in the following description, the term "bubbles", is used to identify air bubbles or voids trapped between the encapsulation foils during the lamination process or bubbles produced by the vapors of the polymer composing the encapsulation foils when it degases due to the heating during the lamination process.

In the following description, the term "performance" is intended to take into account the efficiency and/or safety and/or integrity of the photovoltaic laminate such as its conversion and its life time.

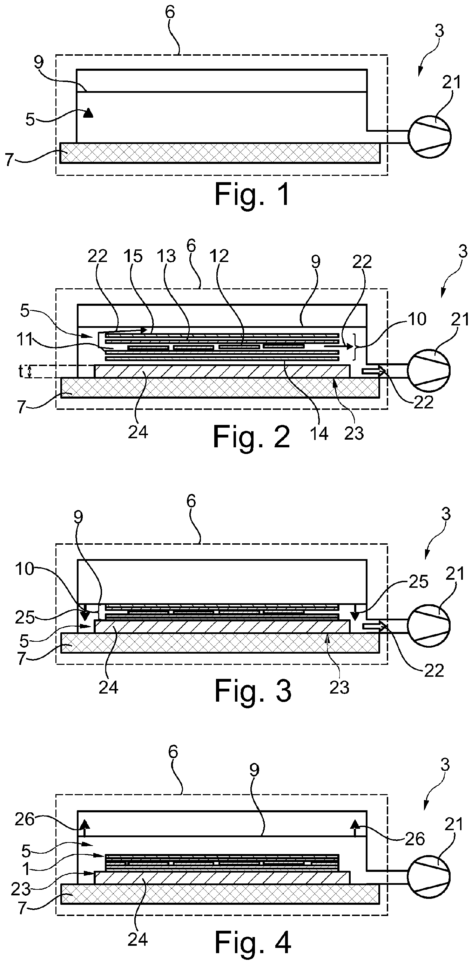

Referring now to figures 1 to 4, there is represented a schematic cross sectional view of a lamination device 3, in particular for the manufacturing of photovoltaic laminates 1 by encapsulation, according to a first embodiment of the present invention. The lamination device 3 comprises a lamination chamber 5 defined by a housing 6. A base plate 7 and a movable top plate 9 are disposed in the housing 6. The lamination chamber 5 is configured for being hermetically closed. For this purpose, the lamination device 3 can be an oven having a door or a bell type furnace.

The base plate 7 is configured to be heated at a predetermined constant temperature to heat a stack of layers 10 aimed at forming the photovoltaic laminate 1. More precisely, the base plate 7 is heated at a constant temperature comprised between 80°C and 200°C, more specifically between 100 and 160°C, to ensure a polymerization reaction of some layers, which are encapsulation foils (11, 13 on figure 2), composing the stack of layers 10 to complete the encapsulation process of the photovoltaic laminate 1. The use of such constant fixed temperature allows to implement commercially available lamination devices which are configured to operate only at a predetermined constant temperature. Naturally, according to the nature of the encapsulation foils 11, 13 used, the heating temperature of the base plate 7 can be adapted in order to get, a polymerization reaction or a glass transition.

During a polymerization reaction for example, the encapsulation foils 11, 13 reticulate, thus this polymerization reaction is irreversible. This ensures a strong adherence between the different layers of the photovoltaic laminate 1 and enhances the resistance against humidity of the photovoltaic laminate 1. However, the control of this reaction is a critical point.

The movable top plate 9 is configured for pressing onto a stack of layers 10 aimed at forming the photovoltaic laminate 1. Effectively, the lamination process is aimed at obtaining photovoltaic laminates 1 having a small thickness. By pressing onto the stack of layers 10 with the movable top plate 9 during the polymerization reactions, it is possible to obtain a very strong adherence between the different layers composing the photovoltaic laminate 1 due to the reticulation of the polymer composing the encapsulation foils 11, 13 and a small thickness of this laminate. Nonetheless, due to the fact that those reactions are irreversible, it is necessary to pay attention to some parameters.

It has been showed that to enhance the performance of the photovoltaic laminates 1, it is necessary to avoid the presence of bubbles between the different layers composing this photovoltaic laminate 1. To avoid the presence of bubbles it is necessary to degas the lamination chamber 5 before the starting of the polymerization reaction, the thermoplastic deformation or the glass transition of the encapsulation foils 11, 13. To achieve this air removal, the lamination device 3 has a vacuum pump 21 which ensures the degassing of the lamination chamber 5 and in particular of the air between the layers of the stack 10 and vapor produced by the encapsulation foils 11 and 13.

Furthermore, the lamination device 3 has a support structure 23 which can be removed from the lamination chamber 5 and onto which the stack of layers 10 aimed at forming the photovoltaic laminate 1 after the lamination process is disposed. The support structure 23 may be realized as a plate 24 presenting a predetermined thermal inertia, a predetermined surface thermal resistance and a predetermined bulk thermal resistance to slow down the temperature rise of the stack of layers 10 and so delay the starting of the polymerization reaction or glass transition of the encapsulation foils disposed into the stack of layers 10.

According to the particular embodiment of figure 2, the stack of layers 10 is composed by at least a layer of strings of photovoltaic cells 12 sandwiched between encapsulation foils 11, 13. The stack of layers 10 further comprises an optional back-sheet layer 14 and an optional front-sheet layer 15.

According to this particular embodiment, the encapsulation foils 11, 13 are made of simple basic monomers such as EVA or epoxy monomers for example.

Moreover, the optional back-sheet layer 14 is made of any suitable material resistant to external aggressions such as ultraviolet radiations, corrosive atmospheres, temperature, abrasion, or chemicals. This back-sheet layer 14 is aimed at being the back-face of the photovoltaic laminate 1. More precisely the back-face is the last face receiving the light radiations of the photovoltaic laminate 1. This back-face is aimed at being partially in contact with the building structure onto which the photovoltaic laminate 1 is disposed for example. Furthermore, the optional back-sheet layer 14 can have connection output modules (not shown) to output the produced photovoltaic energy to the inverters for example.

Then, the front-sheet layer 15 is made of any material having a good optical transmission, such as for example more than 95% in the useful range of the solar spectrum. This front-sheet layer 15 is aimed at being the first layer to be exposed to the solar light radiations. Generally, this front-sheet layer 15 is made for example of transparent plastic material in order to allow the greatest part of the light radiation to pass through this front-sheet layer 15 to the strings of photovoltaic cells 12 to maximize the photovoltaic conversion of the photovoltaic laminate 1.

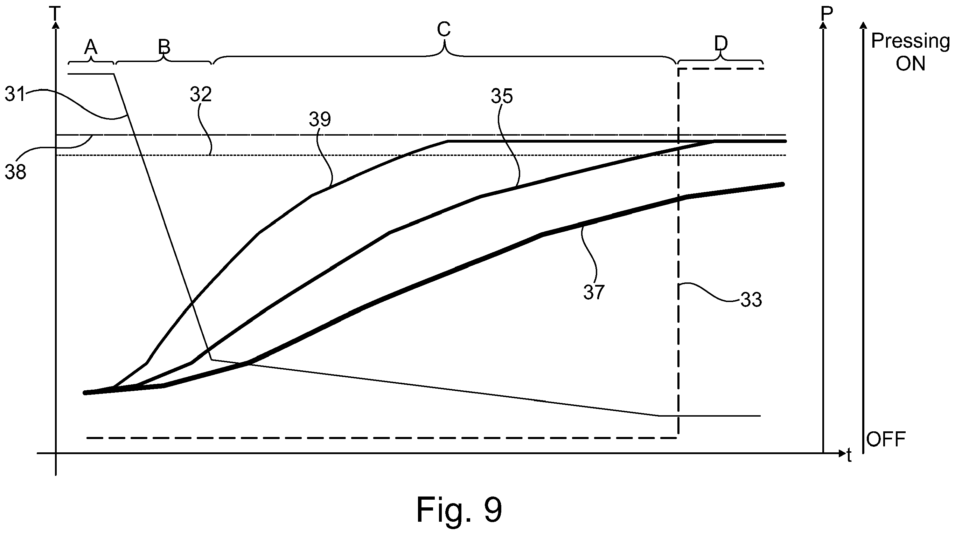

Referring to figures 2 to 4, the plate 24 with a predetermined thermal inertia, a predetermined surface thermal resistance and a predetermined bulk thermal resistance is made for example of glass. In a general manner, the plate 24 has a thickness t comprised between 0,1 mm and 20 mm. According to this specific embodiment, the plate 24 has a thickness t comprised between 2 mm and 10 mm. Effectively, as it will be explained later, the thickness t of the plate 24 has to be chosen in order to slow down the rise in temperature of the stack of layers 10. The thickness t of the plate 24 has to be chosen to allow the temperature of the stack of layers 10 to reach a predetermined threshold temperature 32 for polymerization or glass transition of the encapsulation foils 11, 13 (represented on figure 9) in an acceptable time, and thus the lamination process would be efficient only after bubbles have been suppressed from the stack of layers 10.

Moreover, to ensure an optimal slow down of the temperature rise of the stack of layers 10, the predetermined thermal inertia of the plate 24, the surface thermal resistance with respect to the base pate 7 and the bulk thermal resistance of the plate 24 are parameters which should be carefully chosen.

The use of a plate 24 having such characteristics ensures the delay of the starting of the polymerization reaction or the glass transition, and thus optimizes the control of the lamination process. Moreover, the use of such plate 24 enables the creation of a thermal resistance at the interface of this plate 24 with the base plate 7, contributing to the delay of the temperature rise of the stack of layers 10.

According to another embodiment not represented there, the plate 24 can be made of metal, glass, glass comprising thermal conductive particles, polymer, phase change material, ceramic, or a combination of those different materials.

Before introduction into the lamination chamber 5, the stack of layers 10 and the support structure 23 are at room temperature, such as 22°C for example.

Referring to figure 2, the stack of layers 10 disposed onto the support structure 23 is introduced into the lamination chamber 5 between the base plate 7 and the movable top plate 9 of the lamination device 3. This introduction of the support structure 23 into the lamination chamber 5 corresponds to a first step A of deposition. According to this embodiment, the base plate 7 is at a predetermined fixed constant temperature of 135°C when the first step A of deposition is performed. This constant temperature of the base plate 7 will be maintained during all the lamination process. However, according to the composition of the encapsulation foils 11, 13 used, this temperature can be changed. In a general manner, this fixed constant temperature corresponds to the polymerization temperature of the monomers or glass transition of the material composing the encapsulation foils 11, 13.

The door of the lamination device 3 is closed and the vacuum pump 21 runs to pump-down and degas the lamination chamber 5 to remove the air and the vapors produced by the degassing of the monomer composing the encapsulation foils 11, 13 from the lamination chamber 5 and between the layers of the stack according to the arrows 22 (represented in figure 2). The degassing of the lamination chamber 5 is necessary to avoid the formation of bubbles between the layers of the photovoltaic laminate 1 and thus enhancing its performance. The use of the vacuum pump 21 to pump-down and degas the lamination chamber 5 corresponds to a second step B and a third step C corresponding respectively to a pumping down and to a degassing step. Advantageously, the pumping down B and degassing C steps are performed for a period of less than 10 minutes, and in particular comprised between 30s and 2 minutes. However, those times can be reviewed according to the volume of the lamination chamber 5, the power of the vacuum pump 21 used and/ or the degassing material.

Referring to figure 3, the stack of layers 10 is then pressed with the movable top plate 9 according to the arrows 25 during a predetermined time in order to realize the lamination step. This lamination step corresponds to a fourth step D. The duration of this fourth step D is variable and depends on various parameters such as the number of layers constituting the stack of layers 10 or the composition of the encapsulation foils 11, 13 used for example. During this fourth step D, the vacuum pump 21 runs and maintains the pressure into the lamination chamber 5 under a predetermined threshold pressure. In order to avoid any formation of bubbles between the layers of the photovoltaic laminate 1, the pressure into the lamination chamber 5 has to be less than 20mbar at the starting of the fourth step D. According to this particular embodiment, the pressure into the lamination chamber 5 at the starting of the pressing step D and during all this step is equal to 1 mbar.

Referring to figure 4, once the predetermined time of the fourth step D is over, the movable top plate 9 is moved up according to the arrows 26 and the lamination chamber 5 is vented in order to allow the opening of the door of the lamination device 3 and the remove of the laminated photovoltaic laminate 1 from this lamination device 3. A further stack of layers 10 disposed on a support structure 23 to be laminated can be deposited into the lamination chamber 5 directly after this removing step and the lamination process can be implemented again.

According to a possible variant, the fourth step D can be performed after a predetermined time after the first step A of the support structure 23 with the stack of layers 10 into the lamination chamber 5. According to this particular embodiment, the volume of the lamination chamber 5 and the power of the vacuum pump 21 have to be known to ensure the removal of the air and degassing vapors inside the lamination chamber 5.

Naturally, this fourth step D of pressing onto the stack of layers 10 with the movable top plate 9 can be manually or automatically performed. When the fourth step D is automatically performed, it can be controlled by some electronic control unit (not shown) for example.

Advantageously, the use of the support structure 23 allows the use of a conventional lamination device 3 which is configured for heating at a predetermined constant temperature for temperature stability purposes. Thus, it is possible to control the temperature rise of the stack of layers 10 and to control the starting of the polymerization reaction or glass transition and thus decreasing the number of laminated photovoltaic laminates 1 to throw away because of non-controlled polymerization reactions or other thermal problems during the lamination process. Effectively, the support structure 23 provides a surface thermal resistance enabling the delay of the temperature rise of the stack of layers 10 and also the starting of the polymerization reaction of the encapsulation foils 11, 13. Moreover, the use of this support structure 23 creates a thermal resistance at the interface between the base plate 7 and the support structure 23 contributing to delay the temperature rise of the stack of layers 10 too.

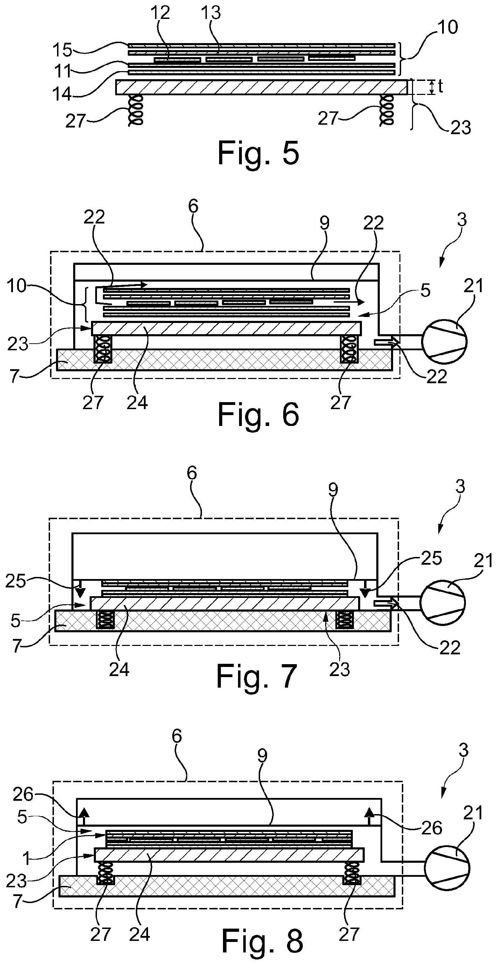

Now referring to figure 5, there is represented the support structure 23 onto which the stack of layers 10 is disposed according to a second embodiment. The support structure 23 has the plate 24 and further comprises mechanical springs 27. The plate 24 may have the same characteristics (thickness t and thermal inertia) than in the first embodiment or be only of less thermal inertia. The mechanical springs 27 are configured for maintaining the support structure 23 above the base plate 7 of the lamination device 3 as illustrated in figure 6 during the second step B and third step C for example. The gap between the base plate 7 and the support structure 23 can provide the desired thermal resistance. The mechanical springs 27 are configured for collapsing due to the pressure of the movable top plate 9 onto the stack of layers 10 to bring the support structure 23 into contact with the base plate 7 during the fourth step D as represented by figure 7. The use of such support structure 23 comprising mechanical springs 27 can improve the slow down of the temperature rise of the stack of layers 10 if necessary because the support structure 23 would not be in contact with the heated base plate 7 directly after the first step A (figure 6). Thus, the heating by low pressure conduction or convection of the stack of layers 10 can be delayed. Moreover, as previously explained, the use of this support structure 23 provide a surface thermal resistance to enable the delay of the temperature rise of the stack of layers 10 and thus the starting of the polymerization reaction of the encapsulation foils 11, 13.

According to another embodiment not represented there, the mechanical springs 27 can be replaced by actuators which could be driven automatically by a control unit or manually by an operator to bring into contact the support structure 23 and the heated base plate 7 after a predetermined time after the deposition of the support structure 23 into the lamination chamber 5 for example. In such a case, the actuators would advantageously be directly disposed into the lamination chamber 5.

Referring to figure 8, the lamination device 3 is represented during the venting step. During this step, the movable top plate 9 is moved up according to the arrows 26 and the mechanical springs 27 are allowed to spring back to their normal length.

Advantageously, the use of those mechanical springs 27 can facilitate the deposition of the support structure 23 onto which the stack of layers 10 is placed into the lamination chamber 5 or the removal of the support structure 23 onto which is the laminated photovoltaic laminate 1 formed from the lamination chamber 5 at the end of the lamination process. In addition, this embodiment allows to enhance the cooling speed in air thanks to a potential lower thermal inertia.

Referring to figure 9, there is represented a graph illustrating the lamination process according to the first embodiment of the invention. On this graph, the abscissa axis illustrates the time t and the ordinate axes illustrate the pressure P into the lamination chamber 5and the temperature T of the laminate 10. Moreover another ordinate axis represents if the pressing of the movable top plate 9 is active (ON) or not (OFF). The curve 31 corresponds to the pressure into the lamination chamber 5. Furthermore, the curve 33 illustrates the pressure applied by the movable top plate 9 onto the stack of layers 10. Moreover, the dotted line illustrates the threshold temperature Tₜₕ 32 for polymerization or glass transition of the encapsulation foils 11, 13 used. The dot-dash line 38 represents the laminator temperature, asymptote temperature for the laminate 10.

Then, the temperature of the stack of layers 10 is represented by three curves 35, 37, 39 according to different embodiments: on the one hand an ideal embodiment (curve 35) in which the plate 24 of the support structure 23 has an optimal thickness t and an optimal thermal inertia and surface and bulk thermal resistance., and on the other hand two counter examples (curves 37 and 39) in which the plate 24 has a too high thickness t and/or a too high thermal inertia and/or a too high surface / bulk thermal resistance (curve 37) or a too low thickness t and/or a too low thermal inertia and/or a too low surface / bulk thermal resistance (curve 39). Moreover, at the top of this flowchart, are represented the different steps (A, B, C, D) in order to better illustrate the conditions into the lamination chamber 5, such as the temperature T and the pressure P, during those different steps and the time t of each step.

At the first step A, the base plate 7 being heated at the predetermined constant temperature, the plate supporting the stack of layers 10 to be laminated is disposed onto the base plate 7. At this time, the stack of layers 10 is substantially at room temperature T_{R}, such as 22°C for example, and the pressure into the lamination chamber 5 is at atmospheric pressure P_{A} (substantially 1 bar).

The lamination chamber 5 is closed and the vacuum pump 21 is started to perform the second step B of pumping down. During this second step B, the pressure inside the lamination chamber 5 decreases to reach a first predetermined threshold pressure Pₜₕ₁ which is for example approximately less than 20 mbar like for example 5 mbar, and the temperature of the stack of layers starts to rise in temperature.

Then in the third step C, the vacuum pump 21 continues to pump and evacuates out of the lamination chamber 5 the air and the vapors disposed between the different layers of the stack of layers 10 in order to avoid any bubble formation into the encapsulation foils which could impact the performance of the photovoltaic laminate 1 (as illustrated by the arrows 22 in figures 2 and 6). During this third step C the pressure in the lamination chamber 5 decreases to reach a second predetermined threshold pressure Pₜₕ₂, the temperature of the stack of layers 10 even raises as illustrated by the curves 35, 37, and 39.

If the plate 24 has a too low thickness and/or a too low thermal inertia and/or a too low surface / bulk thermal resistance (curve 39), the polymerization threshold or glass transition temperature 32 is reached before degassing is completed. Thus, the polymerization reaction will starts before the lamination chamber 5 is degassed and air and/ or gas vapors will remain between and in the layers of the stack. Additionally, the reticulation before pressing will not permit a good adherence between the layers of the stack 10. With thermoplastic material, reaching glass transition before pressing will induce a flow of material and uncontrolled encapsulation. So, the formation of bubbles inside the reticulated encapsulation layers 11, 13, adhesion issues or materials flow occurs and impacts the performance of the photovoltaic laminate 1.

At the end of the third step C, the pressure inside the lamination chamber 5 is less than 20 mbar for example less than 5 mbar and more preferably equal to Pₜₕ₂ = 1 mbar. With such a pressure inside the lamination chamber 5, the formation of bubbles between the different layers of the stack is avoided. This pressure is reached just before the starting of the fourth step D of pressing. As illustrated by curve 35, the stack of layers 10 reaches the predetermined threshold temperature 32 for polymerization or glass transition just after the completion of degassing during the third step C due to the use of the plate 24 having a predetermined thermal inertia and /or surface / bulk thermal resistance.

The fourth step D is then performed by the use of the movable top plate 9 which presses onto the stack of layers 10 to form the photovoltaic laminate 1 as represented by curve 33. This fourth step D of pressing ensures the formation of a strong adherence between the different layers composing the stack to obtain the laminated photovoltaic laminate 1 and avoids any voids in the laminate 1. Advantageously, the pressure applied by the movable top plate 9 onto the stack of layer is substantially equal to 1 bar. Effectively, this applied pressure has to be high enough to press the different layers of the stack together but not too high in order not to damage the components of the different layers of the stack. Moreover, if the pressure is too high, it can weaken or break some layers of the stack or flow to much vicious material during this fourth step D of pressing.

In order to ensure the adherence between the different layers of the stack, the fourth step D has to be done after completion of degassing and before the stack of layers 10 has reached the predetermined polymerization threshold or glass transition temperature 32.

If the temperature of the stack of layers 10 is less than this polymerization threshold temperature, the encapsulation foils 11, 13 would not reticulate and the adherence between the different layers of the photovoltaic laminate 1 would not be guaranteed. As illustrated by curve 37, at the beginning of the fourth step D, the temperature of the stack of layers 10 is beneath the predetermined threshold temperature 32 for polymerization or glass transition of the encapsulation foils 11, 13 because the plate 24 of the support structure 23 has a too high thickness t or a too high thermal inertia and or too high surface / bulk thermal resistance. Thus, the reticulation or glass transition of the encapsulation foils 11, 13 would not happen and the strong adhesion between the different layers would not be guaranteed.

In order to traverse this drawback, it can be possible to install a temperature sensor (not represented) like infrared thermometer into the lamination chamber 5. By the use of such sensors, the pressing step D can be performed once the stack of layers 10 has reached a predetermined threshold temperature Tₜₕ 32. However, the use of a plate 24 having a too high thickness t or a too high thermal inertia and / or a too high surface / bulk thermal resistance will lead to an increase of the processing times and would not necessary be cost effective.

The here-above embodiments are illustrative and not restrictive embodiments. Obviously, many modifications and variations of the present invention are possible in the light of the above teachings without deviating from its inventive concept. It has therefore to be understood that the invention may be practiced otherwise than as specifically described. Effectively, it is possible for the man skilled in the art to use a temperature sensor to follow the rise in temperature of the stack of layers 10 in order to adapt the thickness t or the thermal inertia of the plate 24, or to command the movement of the movable top plate 9 when the polymerization threshold value or glass transition 32 is reached by the stack of layers 10 for example.

Thus, the improvement of the lamination process for the manufacturing of a photovoltaic laminate 1 by encapsulation is possible due to the support structure 23 having a plate 24 presenting a predetermined thickness t and a predetermined thermal inertia. Effectively, the use of such plate 24 delays the starting of the polymerization, even if the lamination device 3 is heated at a predetermined constant temperature, which generally corresponds to the polymerization threshold or glass transition temperature 32 of the encapsulation foils used, to allow the degassing of the lamination chamber 5 before the starting of the polymerization reaction or material softening to avoid the presence of bubbles between the layers of the stack to ensure a good performance to the photovoltaic laminate 1 obtained by this process.

## Claims

**1.** Lamination process, in particular for manufacturing photovoltaic laminates (1) by encapsulation, using a lamination device (3) comprising a lamination chamber (5) having a base plate (7) and a movable top plate (9), said lamination process comprising the steps of:
• heating the base plate (7) at a predetermined temperature,
• depositing (A) a stack of layers (10) aimed at forming the photovoltaic laminate (1) into the lamination chamber (5) between the base plate (7) and the movable top plate (9),
• pumping down (B) and degassing (C) the lamination chamber (5) by the use of a vacuum pump (21),
• pressing (D) onto the stack of layers (10) with the movable top plate (9) during a predetermined time in order to realize a lamination step,
• venting the lamination chamber (5), and
• removing the laminated photovoltaic laminate (1) formed from the lamination chamber (5),
wherein the stack of layers (10) is placed on a support structure (23) configured for providing a predetermined thermal inertia, a predetermined bulk thermal resistance, and a predetermined surface thermal resistance between the base plate (7) and the stack of layers (10) to slow down the temperature rise of the stack of layers (10) and delay polymerization and /or glass transition between the layers of the stack.

**2.** Lamination process according to claim 1 wherein said support structure comprises a plate (24) made of metal, glass, glass comprising thermal conductive particles, polymer, phase change material, ceramic, or a combination thereof.

**3.** Lamination process according to any one of claims 2 wherein the plate (24) has a thickness (t) comprised between 0,1 mm and 20 mm, and more preferably comprised between 3 mm and 10 mm.

**4.** Lamination process according to any one of the preceding claims wherein the base plate (7) is heated at a constant temperature which is comprised between 80 and 200°C.

**5.** Lamination process according to any one of the preceding claims wherein the pumping down (B) and degassing (C) steps are performed for a period of less than 10 minutes, and in particular comprised between 30s and 2 minutes.

**6.** Lamination process according to any one of the preceding claims taken in combination with claim 2, wherein the plate (24) has a predetermined thermal inertia, a predetermined surface thermal resistance with respect to the base plate (7) and a predetermined bulk thermal resistance such that the steps of pumping down (B) and of degassing (C) are completed before the stack of layers (10) reaches a predetermined polymerization or glass transition threshold temperature (32).

**7.** Lamination process according to any one of the preceding claims wherein the step (D) of pressing is performed after a predetermined time after the step (A) of deposition of the support structure (23) with the stack of layers (10) into the lamination chamber (5).

**8.** Lamination process according to any one of claims 1 to 7 wherein the step (D) of pressing is performed once the pressure into the lamination chamber (5) is lower than a predetermined threshold.

**9.** Lamination process according to claim 8 wherein the predetermined threshold is 20 mbar, and more preferably 1 mbar.

**10.** Lamination process according to claim 9 taken in combination with claim 6, wherein the plate (24) has a predetermined thermal inertia, a predetermined surface thermal resistance with respect to the base plate (7) and a predetermined bulk thermal resistance such that the predetermined threshold temperature (32) for polymerization or glass transition of encapsulation foils (11, 13) is not yet reached when the pressure in the lamination chamber (5) is equal to 1 mbar.

**11.** Lamination process according to any one of the preceding claims, wherein the support structure (23) comprises mechanical springs (27) configured for collapsing by the pressure of the movable top plate (9) onto the stack of layers (10) to bring the support structure (23) into contact with the base plate (7) during the pressing step (D).

**13.** Lamination device (3), in particular for manufacturing photovoltaic laminates (1) by encapsulation, said lamination device (3) comprising a base plate (7) configured to be heated at a predetermined constant temperature and a movable top plate (9) configured for pressing onto a stack of layers (10) aimed at forming the photovoltaic laminate (1), said lamination device (3) further comprising a support structure (23) on which the stack of layers (10) is placed on and configured for providing a predetermined thermal inertia, a predetermined bulk thermal resistance, and a predetermined surface thermal resistance between the base plate (7) and the stack of layers (10) to slow down the temperature rise of the stack of layers (10) and delay polymerization and /or glass transition between the layers of the stack.
